# EUROPÄISCHE PATENTSCHRIFT

(11) **EP 4 154 482 B1**
(45) Veröffentlichungstag und Bekanntmachung des Hinweises auf die Patenterteilung: **26.11.2025**
(21) Anmeldenummer: 21720742.2
(22) Anmeldetag: 21.04.2021
(51) Int. Cl.: H04L 25/02

(54) **VERFAHREN UND EINRICHTUNG ZUM DÄMPFEN VON SCHWINGUNGEN AUF BUSLEITUNGEN EINES AUF DIFFERENZSPANNUNGSSIGNALEN BASIERENDEN BUSSYSTEMS**
METHOD AND DEVICE FOR ATTENUATING OSCILLATIONS ON BUS LINES OF A BUS SYSTEM BASED ON DIFFERENTIAL VOLTAGE SIGNALS
PROCÉDÉ ET DISPOSITIF D'ATTÉNUATION D'OSCILLATIONS SUR DES LIGNES DE BUS D'UN SYSTÈME DE BUS SUR LA BASE DE SIGNAUX DE TENSION DIFFÉRENTIELLE

(30) Priorität: 22.05.2020 DE 102020206411
(43) Veröffentlichungstag der Anmeldung: 29.03.2023
(73) Patentinhaber: Robert Bosch GmbH, 70442 Stuttgart (DE)
(72) Erfinder: WALKER, Steffen, 72770 Reutlingen (DE); STEGEMANN, Sebastian, 72072 Tuebingen (DE)
(86) Internationale Anmeldenummer: PCT/EP2021/060377
(87) Internationale Veröffentlichungsnummer: WO 2021/233635

(56) Entgegenhaltungen:
- DE-A1- 102018 206 929
- KIM GYUNHA ET AL: "Ringing Suppression in a Controller Area Network With Flexible Data Rate Using Impedance Switching and a Limiter", IEEE TRANSACTIONS ON VEHICULAR TECHNOLOGY, IEEE SERVICE CENTER, PISCATAWAY, NJ, US, vol. 68, no. 11, 1 November 2019 (2019-11-01), pages 10679 - 10686, XP011754932, ISSN: 0018-9545, [retrieved on 20191111], DOI: 10.1109/TVT.2019.2926763

## Beschreibung

Die vorliegende Erfindung betrifft eine Dämpfungseinrichtung für ein auf Differenzspannungssignalen basierendes Bussystem sowie ein Verfahren zum Dämpfen von Schwingungen.

### Stand der Technik

In Bussystemen, insbesondere in solchen, die Signale in Form von Spannungsdifferenzen zwischen zwei leitenden Drähten, den sogenannten Busleitungen, übertragen, wie z.B. dem CAN-Bus (CAN steht für Controller Area Network), treten im Verlauf der Spannungsdifferenz an den bzw. nach den Flanken des Differenzspannungssignals Schwingungen auf. Beispielsweise treten solche Schwingungen im CAN-Bus nach dem Übergang von einem dominanten Zustand, in dem eine Spannungsdifferenz von nominal 2 V besteht, in einen rezessiven Zustand, in dem eine Spannungsdifferenz von nominal 0 V besteht, auf. Die Schwingungen des Bussystems werden durch Schaltvorgänge der Bussignale aufgrund von Leitungsinduktivitäten und Eingangskapazitäten der Transceiver des Bussystems verursacht. Diese Spannungs-Schwingungen werden auch als "Ringing" bezeichnet.

Negativer Effekt dieser Schwingungen ist, dass die maximale Bitrate, die über den Bus übertragen werden kann, beschränkt ist, da durch die Schwingungen die Zeitspanne, bis nach einer Änderung des Differenzspannungssignals ein zuverlässig erkennbarer Signalzustand eingenommen wird, vergrößert wird. Dieser Effekt ist beispielsweise eine wesentliche Ursache dafür, dass die effektiv nutzbare Bitrate in einem nominal auf 5 MBit/s ausgelegten CAN-FD-Bus (FD: Flexible Data Rate), auf ca. 2 MBit/s beschränkt ist.

Um die effektiv nutzbare Bitrate zu vergrößern, kann daher versucht werden, die Schwingungen bzw. das Ringing zu unterdrücken bzw. zu dämpfen. Etwa betreffen die Neuerungen in den CAN-FD-SIC-Anforderungen (SIC: Signal Improvement Capability), die an Transceiver im Bussystem gestellt werden, gegenüber den CAN-FD-Anforderungen insbesondere das Dämpfungsverhalten beim Übergang vom dominanten in den rezessiven Zustand. Hierzu können die beiden Busleitungen während des Zeitraums, in dem die Spannungsschwingungen auftreten, möglichst niederohmig, d.h. mit möglichst kleinem oder keinem Widerstand, verbunden werden. Dies hat zur Folge, dass während dieses Zeitraums andere Busteilnehmer für das Erzeugen einer Spannungsdifferenz auf dem Bus einen größeren Strom benötigen.

G. Kim and H. Lim, "Ringing Suppression in a Controller Area Network With Flexible Data Rate Using Impedance Switching and a Limiter", IEEE Transactions on Vehicular Technology, vol. 68, no. 11, 1 November 2019 (2019-11-01), pages 10679 - 10686, ISSN: 0018-9545, DOI: 10.1109/TVT.2019.2926763 schlägt eine Ringing-Unterdrückungsschaltung vor, die einen Widerstand und eine Diode umfasst. DE 10 2018 206 929 A1 betrifft eine Schaltung für ein Bussystem, die eine Ermittlungsschaltung und eine Unterdrückungsschaltung umfasst, wobei die Unterdrückungsschaltung zugeschaltet wird, wenn durch die Ermittlungsschaltung eine steigende Flanke eines Sendeeingangssignals ermittelt wird.

### Offenbarung der Erfindung

Erfindungsgemäß werden eine Dämpfungseinrichtung für einen Bus eines auf Differenzspannungssignalen basierenden Bussystems, insbesondere eines Controller-Area-Network-Bussystems, ein Verfahren zum Dämpfen von Schwingungen und eine Dämpfungsanordnung mit den Merkmalen der unabhängigen Patentansprüche vorgeschlagen. Vorteilhafte Ausgestaltungen sind Gegenstand der Unteransprüche sowie der nachfolgenden Beschreibung.

Entsprechend der Erfindung kann der elektrische Widerstandswert zwischen den Busleitungen während eines Zeitraums nach Auftreten einer Flanke im Differenzspannungssignal gezielt gesteuert werden. Damit wird einerseits eine Dämpfung von Schwingungen der Differenzspannung erreicht und andererseits kann gewährleistet werden, dass auch schwache Busteilnehmer (d.h. Busteilnehmer, die zur Erzeugung einer Spannungsdifferenz auf dem Bus relativ wenig Strom bereitstellen können) eine Spannungsdifferenz auf dem Bus erzeugen können, um einen Fehler anzuzeigen (also ein sogenanntes Error-Flag senden können).

Die Dämpfungseinrichtung weist dazu eine Dämpfungsschaltung auf, die in einem ersten Schaltungszustand die Busleitungen (eine erste Busleitung (z.B. CAN_H) und eine zweite Busleitung (z.B. CAN_L)) durch einen sehr niedrigen Widerstandswert miteinander verbindet bzw. kurzschließt, wodurch die Schwingung stark gedämpft wird. In einem zweiten Schaltungszustand wird bzw. ist der Widerstandswert erhöht, so dass auch schwächere Bus-Teilnehmer eine Differenzspannung auf dem Bus erzeugen können, wobei gleichzeitig der Widerstandswert immer noch klein genug ist, um die Schwingung weiter zu dämpfen. In einem dritten Schaltungszustand sind die Busleitungen über die Dämpfungsschaltung nicht mehr, bzw. nur mit sehr hohem bzw. unendlichem Widerstandswert, miteinander verbunden.

Die Dämpfungseinrichtung weist auch eine Steuerschaltung auf, welche die Dämpfungsschaltung zwischen den einzelnen Schaltungszuständen hin- und herschaltet, z.B. nach Maßgabe von Ansteuersignalen.

Besonders vorteilhaft können diese unterschiedlichen Widerstandswerte durch eine Schaltung aufweisend wenigstens einen Halbleiterschalter erzeugt werden. Besonders vorteilhaft wird der variable Widerstandswert durch den Ein-Widerstand (z.B. R_{DSon}) wenigstens eines Halbleiterschalters, vorzugsweise von wenigstens zwei antiseriell geschalteten Halbleiterschaltern erzeugt. Durch unterschiedliche Ansteuerung dieses wenigstens einen Halbleiterschalters können besonders einfach unterschiedliche Widerstandswerte erzeugt werden, von einem sehr geringen Widerstand (Halbleiterschalter ist durchgesteuert) bis hin zu einem sehr hohen bzw. unendlichen Widerstand (Halbleiterschalter sperrt).

Gemäß einer bevorzugten Ausführungsform der Erfindung ist der wenigstens eine Halbleiterschalter ein Feldeffekttransistor, FET, insbesondere MOSFET. Feldeffekttransistoren eignen sich aufgrund ihrer intrinsischen Streukapazitäten besonders gut zum Einstellen zeitlich variabler Widerstandswerte.

Vorzugsweise umfasst die Dämpfungsschaltung einen ersten Feldeffekttransistor, FET, mit einer vorbestimmten Gate-Source-Kapazität, einen zweiten FET mit einer vorbestimmten Gate-Source-Kapazität und ein Widerstandselement mit einem vorbestimmten Widerstandswert, wobei ein Drainanschluss des ersten FET mit einem Anschluss für die erste Busleitung verbunden ist und ein Drainanschluss des zweiten FET mit einem Anschluss für die zweite Busleitung verbunden ist, wobei ein Sourceanschluss des ersten FET und ein Sourceanschluss des zweiten FET mit einem gemeinsamen Sourceanschlusspunkt verbunden sind, wobei ein Gateanschluss des ersten FET und ein Gateanschluss des zweiten FET mit einem gemeinsamen Gateanschlusspunkt verbunden sind, und wobei das Widerstandselement mit dem Sourceanschlusspunkt und dem Gateanschlusspunkt verbunden ist. Vorzugsweise handelt es sich um selbstsperrende p-Kanal-FET.

Weiter vorzugsweise ist die Steuerschaltung mit dem Gateanschlusspunkt und dem Sourceanschlusspunkt der Dämpfungsschaltung verbunden und ist dazu eingerichtet, einen Spannungsanschluss, einen Bezugspotentialanschluss und mindestens einen Steueranschluss aufweist, wobei die Steuerschaltung dazu eingerichtet ist, wenn an dem Spannungsanschluss eine Spannung anliegt und an dem Bezugspotentialanschluss ein Bezugspotential anliegt:
1. den Sourceanschlusspunkt mit dem Spannungsanschluss zu verbinden und den Gateanschlusspunkt mit dem Masseanschluss zu verbinden, wenn an dem mindestens einen Steueranschluss mindestens eine Spannung anliegt, die einen ersten Zustand bzw. den ersten Schaltungszustand signalisiert;
2. den Sourceanschlusspunkt und den Gateanschlusspunkt in der Steuerschaltung offen zu schalten, wenn an dem mindestens einen Steueranschluss mindestens eine Spannung anliegt, die einen zweiten Zustand bzw. den zweiten Schaltungszustand signalisiert; und
3. den Sourceanschlusspunkt mit dem Gateanschlusspunkt niederohmig zu verbinden, wenn an dem mindestens einen Steueranschluss mindestens eine Spannung anliegt, die einen dritten Zustand bzw. den dritten Schaltungszustand signalisiert ("niederohmig" ist hier so zu verstehen, dass der ohmsche Widerstand der Verbindung klein relativ zum Widerstandswert des Widerstandselements sein sollte, z.B. kleiner ein 1/10 oder kleiner als 1/100 des Widerstandswerts, also sehr klein oder verschwindend klein).

Die Ausdrücke "Verbindung", "verbunden", "verbinden", usw. beziehen sich jeweils, falls nicht anderes angemerkt, auf elektrisch leitende Verbindungen und sollten entsprechend verstanden werden. Zur Vereinfachung und besseren Lesbarkeit werden statt der Ausdrücke "elektrisch leitendende Verbindung", "elektrisch leitend verbunden", "elektrisch leitend verbinden", usw. die vorstehenden kürzeren Ausdrücke in dieser Anmeldung verwendet.

Dass der Sourceanschlusspunkt und der Gateanschlusspunkt in der Steuerschaltung "offen" geschaltet werden, bzw. "offen" sind, heißt, dass zwischen Sourceanschlusspunkt und Gateanschlusspunkt durch die Steuerschaltung keine (elektrisch leitende) Verbindung besteht, diese Anschlusspunkte also in der Steuerschaltung getrennt bzw. nur hochohmig verbunden sind. Ebenso sind, wenn Sourceanschlusspunkt und Gateanschlusspunkt in der Steuerschaltung "offen" geschaltet sind, Sourceanschlusspunkt und Gateanschlusspunkt von dem Spannungsanschluss, dem Bezugspotentialanschluss und dem mindestens einen Steueranschluss getrennt (falls zu diesen Anschlüssen eine Verbindung vorhanden war), d.h. es besteht keine (elektrisch leitende) Verbindung (bzw. nur eine hochohmige Verbindung) zu diesen Anschlüssen innerhalb der Steuerschaltung. "Getrennt" ist, analog zu "verbunden", so zu verstehen, dass eine elektrische Leitung getrennt bzw. unterbunden wird.

Die drei unterschiedlichen Zustände (bzw. Phasen) werden durch verschiedene Konfigurationen von Spannungswerten und/oder Spannungen an einem oder mehreren Steueranschlüssen signalisiert bzw. codiert. Beispielsweise ist es möglich, einen einzelnen Steueranschluss vorzusehen, der mit drei unterschiedlichen Spannungspegeln, die den drei Zuständen entsprechen, angesteuert wird.

Bevorzugt ist allerdings, zwei Steueranschlüsse vorzusehen, d.h. die Dämpfungseinrichtung ist dergestalt, dass der mindesten eine Steueranschluss einen ersten und einen zweiten Steueranschluss umfasst, wobei der erste Zustand dadurch signalisiert wird, dass an dem ersten Steueranschluss ein Hochpegel-Spannungssignal anliegt und an dem zweiten Steueranschluss kein Spannungssignal anliegt; wobei der zweite Zustand dadurch signalisiert wird, dass an dem ersten Steueranschluss und an dem zweiten Steueranschluss keine Spannungssignale anliegen; und wobei der zweite Zustand dadurch signalisiert wird, dass an dem zweiten Steueranschluss ein Hochpegel-Spannungssignal anliegt und an dem ersten Steueranschluss kein Spannungssignal anliegt. Bei dieser Ausführung muss nur unterschieden werden, ob oder ob nicht an dem jeweiligen Steueranschluss eine Spannung anliegt. Der Ausdruck "Hochpegel-Spannungssignal" heißt, dass die am Steueranschluss anliegende Spannung höher als die Spannung an dem Spannungsanschluss sein sollte.

Bevorzugt weist die Steuerschaltung erste Schaltelemente auf, die dazu eingerichtet sind, eine Verbindung zwischen dem Spannungsanschluss und dem Sourceanschlusspunkt und eine Verbindung zwischen dem Bezugspotentialanschluss und dem Gateanschlusspunkt in einen leitenden Zustand zu schalten, wenn am ersten Steueranschluss ein Hochpegel-Spannungssignal anliegt, und in einen nicht leitenden Zustand zu schalten, wenn am ersten Steueranschluss kein Spannungssignal anliegt; wobei weiter bevorzugt die ersten Schaltelemente einen dritten und einen vierten FET umfassen, wobei Gateanschlüsse des dritten und des vierten FET mit dem ersten Steueranschluss verbunden sind; wobei am meisten bevorzugt ein Sourceanschluss des dritten FET mit dem Spannungsanschluss und ein Drainanschluss des dritten FET mit dem Sourceanschlusspunkt verbunden sind, und ein Sourceanschluss des vierten FET mit dem Bezugspotentialanschluss und ein Drainanschluss des vierten FET mit dem Gateanschlusspunkt verbunden sind.

Gemäß dieser Ausführung können an den Steueranschlüssen anliegende Spannungen direkt verwendet werden, um die ersten Schaltelemente anzusteuern, was vorteilhaft ist, da keine weiteren Schaltungselemente (etwa Gate-Treiber) vorgesehen werden müssen. Dies gilt ebenso für die folgende Ausgestaltung.

Weiterhin weist die Steuerschaltung bevorzugt eine Kurzschlussschaltung, insbesondere aufweisend zweite Schaltelemente, auf, die dazu eingerichtet sind, eine Verbindung zwischen dem Sourceanschlusspunkt und dem Gateanschlusspunkt in einen leitenden Zustand zu schalten, wenn am zweiten Steueranschluss ein Hochpegel-Spannungssignal anliegt, und in einen nicht leitenden Zustand zu schalten, wenn am zweiten Steueranschluss kein Spannungssignal anliegt.

Bevorzugt weisen die zweiten Schaltelemente einen fünften und einen sechsten FET auf, die in Reihe geschaltet sind, wobei Gateanschlüsse des fünften und des sechsten FET mit dem zweiten Steueranschluss verbunden sind; wobei am meisten bevorzugt ein Sourceanschluss des fünften FET mit einem Sourceanschluss des sechsten FET verbunden ist, und ein Drainanschluss des fünften FET mit dem Sourceanschlusspunkt und ein Drainanschluss des sechsten FET mit dem Gateanschlusspunkt verbunden sind. Zusammen mit der vorherigen Ausgestaltung wird ein besonders einfacher Aufbau der Steuerschaltung ermöglicht. Die Feldeffekttransistoren (FETs) sind bevorzugt Metalloxid-Feldeffekt-Transistoren (MOSFETs), bevorzugt selbstsperrende n-Kanal-FET.

Dämpfungseinrichtungen gemäß einer der vorstehenden Ausgestaltungen können in einem erfindungsgemäßen Verfahren zur Dämpfung von Schwingungen auf Busleitungen eines auf Differenzspannungssignalen basierenden Bussystems, insbesondere eines Controller-Area-Network-Bussystems, Verwendung finden. Das Verfahren umfasst ein Erkennen einer Flanke im Differenzspannungssignal; wenn die Flanke erkannt wird, ein Bereitstellen mindestens einer Spannung an dem mindestens einen Steueranschluss, wobei in einem ersten Zeitraum die mindestens eine Spannung gemäß dem ersten Zustand bereitgestellt wird, in einem zweiten Zeitraum, der sich an den ersten Zeitraum anschließt, die mindestens eine Spannung gemäß dem zweiten Zustand bereitgestellt wird, und in einem dritten Zeitraum, der außerhalb des ersten und des zweiten Zeitraums liegt, die mindestens eine Spannung gemäß dem dritten Zustand bereitgestellt wird.

Das Verfahren wird bevorzugt für eine fallende Flanke des Differenzspannungssignals verwendet, d.h. die Flanke ist bevorzugt eine fallende Flanke des Differenzspannungssignals, bzw. der Schritt des Erkennens umfasst ein Erkennen, ob es sich bei der Flanke um eine fallende Flanke handelt. "Fallende Flanke" bezeichnet den Übergang (Flanke) im Spannungssignal von einem Zustand, in dem eine Spannungsdifferenz besteht, zu einem Zustand, in dem keine Spannungsdifferenz besteht. Beim CAN-Bus ist das der Übergang vom dominanten in den rezessiven Zustand.

Das Verfahren kann dergestalt sein, dass wenn die Flanke erkannt wird, in dem ersten Zeitraum an dem ersten Steueranschluss ein Hochpegel-Spannungssignal und am zweiten Steueranschluss kein Spannungssignal bereitgestellt werden, in einem zweiten Zeitraum am ersten und am zweiten Steueranschluss keine Spannungssignale bereitgestellt werden, und in dem dritten Zeitraum am ersten Steueranschluss kein Spannungssignal und am zweiten Steueranschluss ein Hochpegel-Spannungssignal bereitgestellt werden. Weiterhin kann das Verfahren ein Bereitstellen einer Spannung an dem Spannungsanschluss und eines Bezugspotentials an dem Bezugspotentialanschluss umfassen. Damit können die notwendigen Spannungen bzw. Spannungssignale für die vorstehend beschriebene Ausführung der Dämpfungseinrichtung mit zwei Steueranschlüssen bereitgestellt bzw. erzeugt werden.

Die Ansteuerungseinrichtung weist Anschlusselemente zum Verbinden an die erste und die zweite Busleitung und mindestens einen Ausgang, bevorzugt zwei Ausgänge, zum Verbinden an den mindestens einen Steueranschluss auf, und ist dazu eingerichtet ist, alle Verfahrensschritte eines erfindungsgemäßen Verfahrens durchzuführen, wobei vorbestimmte erste und zweite Zeiträume verwendet werden.

Die Ansteuerungseinrichtung kann als Schaltung mit Transistoren und RC-Gliedern realisiert werden, wobei durch die Zeitkonstanten der RC-Glieder die einzelnen Schaltzeitpunkte bzw. Zeiträume bestimmt werden und die Transistoren entsprechend gesteuert werden, die Spannungssignale für den ersten und den zweiten Steueranschluss zu erzeugen. Die spezifische Auslegung einer solchen Schaltung für die Ansteuerungseinrichtung liegt im Ermessen des Fachmanns.

Die Dämpfungsanordnung umfasst mehrere an den Busleitungen parallel geschaltete Dämpfungseinrichtungen. Dabei weisen die vorbestimmte Gate-Source-Kapazität und/oder der vorbestimmte Widerstandswert verschiedener Dämpfungseinrichtungen bevorzugt unterschiedliche Werte auf, wobei mehr bevorzugt RC-Zeitkonstanten (d.h. Zeitkonstanten der durch die Kapazitäten und Widerstände gebildeter RC-Glieder, also das Produkt aus Kapazitätswert und Widerstandswert) verschiedener Dämpfungseinrichtungen unterschiedlich sind. Unabhängig davon kann die Dämpfungsanordnung weiterhin mehrere jeweils mit einer der mehreren Dämpfungseinrichtungen verbundene Ansteuerungseinrichtungen umfassen, wobei bevorzugt der erste und/oder zweite vorbestimmte Zeitraum mindestens zweier verschiedener Ansteuerungseinrichtungen unterschiedlich ist. Durch eine entsprechende Wahl von Gate-Source-Kapazitäten, Widerstandswerten, ersten und zweiten Zeiträumen, und Kombinationen davon, lässt sich der Widerstand zwischen den Busleitungen gezielt einstellen, d.h. das Dämpfungsverhalten kann gezielt gesteuert werden.

Weitere Vorteile und Ausgestaltungen der Erfindung ergeben sich aus der Beschreibung und der beiliegenden Zeichnung.

Die Erfindung ist anhand von Ausführungsbeispielen in der Zeichnung schematisch dargestellt und wird im Folgenden unter Bezugnahme auf die Zeichnung beschrieben.

Kurze Beschreibung der Zeichnungen
Figur 1 zeigt den prinzipiellen Aufbau eines Bussystems;
Figur 2 zeigt ein Blockschaltbild mit einer mit Busleitungen verbundenen Dämpfungseinrichtung;
Figur 3 zeigt den Schaltplan einer erfindungsgemäßen Dämpfungseinrichtung entsprechend einer bevorzugten Ausführungsform; und
Figuren 4A-4C zeigen den Effekt einer erfindungsgemäßen Dämpfungseinrichtung auf die Differenzspannung und den Widerstand zwischen den Busleitungen.

### Ausführungsformen der Erfindung

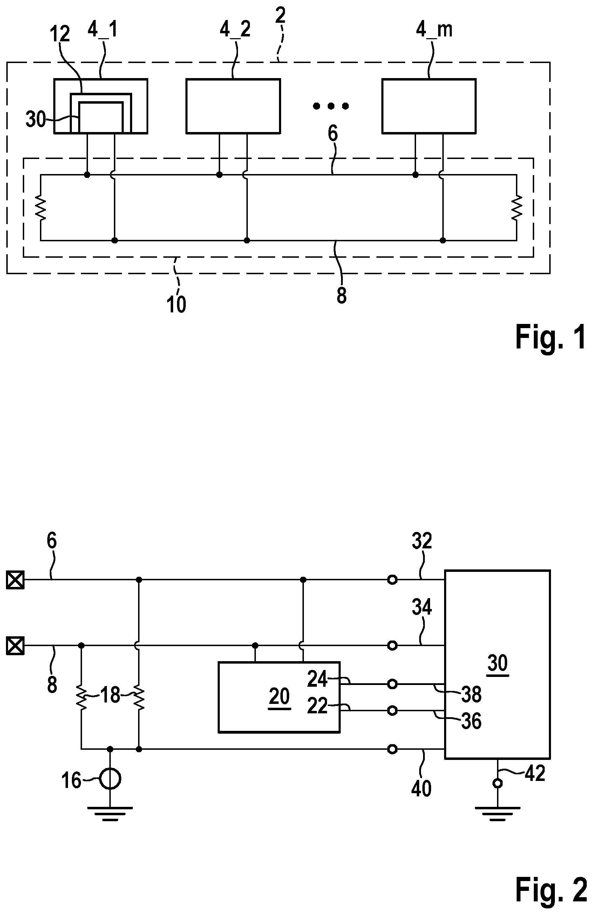

Figur 1 stellt die Struktur eines auf Differenzspannungssignalen basierenden Bussystems 2, insbesondere eines CAN-Bussystems, dar. Das Bussystem 2 umfasst mehrere Bus-Teilnehmer 4_1, 4_2, ..., 4_m, die mit zwei Busleitungen 6, 8 eines Buses 10 des Bussystems verbunden sind und über die Busleitungen miteinander kommunizieren. Dazu verwenden die Bus-Teilnehmer Differenzspannungen zwischen den beiden Busleitungen, die mittels Transceivern erzeugt und ausgelesen werden. In der Figur umfasst einer der Bus-Teilnehmer 4_1, genauer dessen Transceiver 12, eine Dämpfungseinrichtung 30 gemäß der vorliegenden Erfindung, im Allgemeinen können mehrere oder alle Bus-Teilnehmer eine solche umfassen. Die Busleitungen 6, 8 sind über Abschlusswiderstände 14a, 14b miteinander verbunden, die die zentrale Impedanz des Bussystems darstellen.

Figur 2 zeigt ein Blockschaltbild, in dem vereinfacht eine erfindungsgemäße Dämpfungseinrichtung 30 mit den Busleitungen 6, 8 zusammengeschaltet dargestellt ist. Die Dämpfungseinrichtung 30 weist Anschlüsse 32, 34 an eine erste Busleitung 6 bzw. eine zweite Busleitung 8 auf. Im CAN-Bus entspricht die erste Busleitung 6 CAN_H und die zweite Busleitung 8 CAN_L. Als weitere Anschlüsse weist die Dämpfungseinrichtung Steueranschlüsse 36, 38, mit denen die Funktion der Dämpfungseinrichtung gesteuert wird, einen Spannungsanschluss 40 und einen Bezugspotentialanschluss 42, zum Anschluss an ein Bezugspotential, insbesondere an eine Erdung bzw. Masse, auf. Der Spannungsanschluss 40 ist mit einer (idealen) Spannungsquelle 16 verbunden, die eine konstante Spannung bereitstellt und die über Widerstände 18 ebenfalls mit den Busleitungen verbunden ist. Beim CAN-Bus beträgt die von der Spannungsquelle bereitgestellte Spannung nominal 2,5 V, ist also diejenige Spannung, die an beiden Busleitungen im rezessiven Zustand (wenn kein Bus-Teilnehmer eine Differenzspannung erzeugt) anliegt bzw. im dominanten Zustand die Gleichtaktspannung (also der Mittelwert der beiden Spannungen am der ersten und der zweiten Busleitung).

Weiterhin ist in Figur 2 eine Ansteuerungseinrichtung 20 gezeigt, die mit den beiden Busleitungen 6, 8 und mit den beiden Steueranschlüssen 36, 38 der Dämpfungseinrichtung 30 verbunden ist und die dazu eingerichtet ist, die Dämpfungseinrichtung 30 zu steuern, indem sie geeignete Spannungssignale an den Steueranschlüssen 36, 38 der Dämpfungseinrichtung 30 bereitstellt. Die Ansteuerungseinrichtung 20 ist dazu eingerichtet, im Differenzspannungssignal an den Busleitungen eine Flanke zu erkennen, insbesondere soll eine fallende Flanke, d.h. eine Flanke beim Übergang von dem Zustand, in dem eine Spannungsdifferenz vorliegt, zu dem Zustand, in dem keine Spannungsdifferenz vorliegt, erkannt werden. Beim CAN-Bus ist die Ansteuerungseinrichtung also dazu eingerichtet, die Flanke im Differenzspannungssignal beim Übergang von dem dominanten in den rezessiven Zustand zu erkennen. Die Ansteuerungseinrichtung 30 ist weiterhin dazu eingerichtet, an entsprechenden Ausgängen 22, 24, die mit den beiden Steueranschlüssen 36, 38 der Dämpfungseinrichtung 30 zu verbinden sind, Steuerspannungen für die Dämpfungseinrichtung 30 bereitzustellen. Dabei werden an den Ausgängen 22, 24 Spannungen gemäß dreier unterschiedlicher Konfigurationen bzw. Zustände erzeugt. Während einer ersten Phase, die sich über einen ersten Zeitraum direkt nach Erkennen einer absteigenden Flanke erstreckt, liegen Spannungen gemäß einem ersten Zustand an, während einer zweiten Phase, die sich über einen zweiten Zeitraum im Anschluss an den ersten Zeitraum erstreckt, liegen Spannungen gemäß einem zweiten Zustand an, und während der restlichen Zeit, d.h. außerhalb des ersten und des zweiten Zeitraums liegen Spannungen gemäß einem dritten Zustand an. Der dritte Zustand signalisiert, dass die Dämpfungswirkung der Dämpfungseinrichtung ausgeschaltet sein soll.

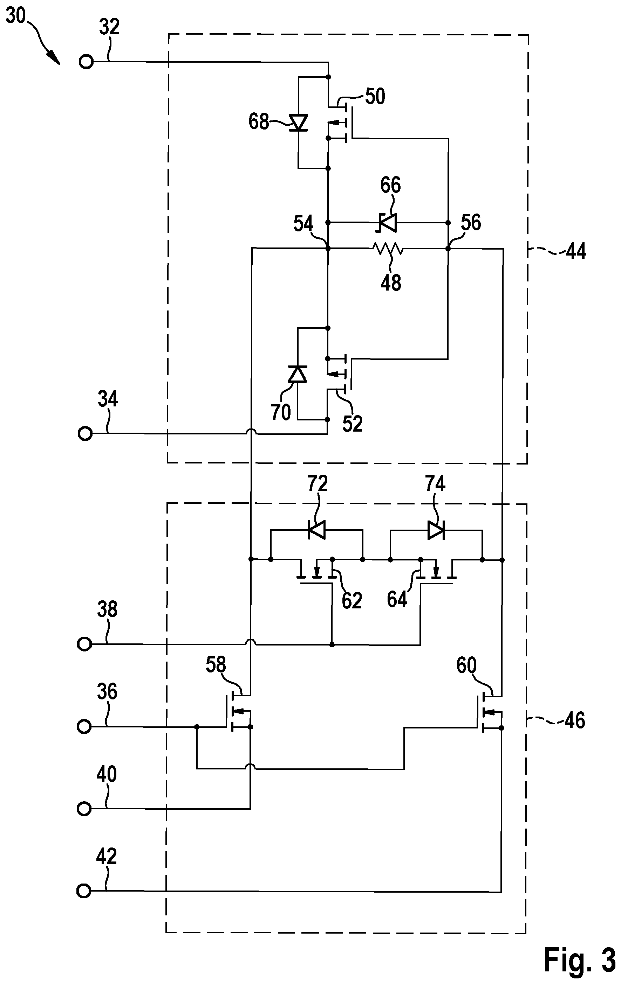

In Figur 3 ist eine bevorzugte Ausführungsform einer erfindungsgemäßen Dämpfungseinrichtung 30 dargestellt. Die Dämpfungseinrichtung umfasst eine Dämpfungsschaltung 44 und eine Steuerschaltung 46.

Die Dämpfungsschaltung 44 weist einen ersten Anschluss 32 für eine erste Busleitung 6 des Busses und einen zweiten Anschluss 34 für eine zweite Busleitung 8 des Busses auf. Die Dämpfungsschaltung 44 umfasst weiterhin ein Widerstandselement 48, das im Weiteren auch als Widerstand 48 bezeichnet wird, einen ersten Feldeffekt-Transistor (FET) 50 und einen zweiten Feldeffekt-Transistor 52. Die beiden Feldeffekt-Transistoren (FETs) 50, 52 sind bevorzugt Metalloxid-Feldeffekt-Transistoren (MOSFETs), weiter bevorzugt p-Kanal MOSFETs vom Anreicherungstyp (d.h. selbstsperrend). Diese Elemente sind dergestalt durch Leitungen miteinander verbunden, dass Sourceanschlüsse des ersten und des zweiten FET 50, 52 mit einem Sourceanschlusspunkt 54 verbunden sind, Gateanschlüsse des ersten und des zweiten FET 50, 52 mit einem Gateanschlusspunkt 56 verbunden sind, der Sourceanschlusspunkt 54 über den Widerstand 48 mit dem Gateanschlusspunkt 56 verbunden ist, der Drainanschluss des ersten FET 50 mit dem ersten Anschluss 32 verbunden ist und der Drainanschluss des zweiten FET 52 mit dem zweiten Anschluss 34 verbunden ist. Der erste und der zweite FET 50, 52 weisen jeweils ein vorbestimmte Gate-Source-Kapazität auf. Der Vollständigkeit halber sind noch Bulk-Drain-Dioden 68, 70 des ersten und zweiten FET 50, 52 eingezeichnet.

Die Steuerschaltung 46 weist einen Spannungsanschluss 40, einen Bezugspotentialanschluss 42 und einen ersten und einen zweiten Steueranschluss 36, 38 auf. Die Steuerschaltung 46 umfasst einen dritten und einen vierten FET 58, 60, deren Gateanschlüsse mit dem ersten Steueranschluss 36 verbunden sind und die bevorzugt MOSFETs sind, weiter bevorzugt n-Kanal MOSFETs vom Anreicherungstyp (d.h. selbstsperrend). Der dritte und der vierte FET stellen erste Schaltelemente dar. Der dritte FET 58 ist so angeordnet, dass er eine Verbindung von dem Spannungsanschluss 40 zu dem Sourceanschlusspunkt 54 zwischen einem leitenden und einem nicht leitenden Zustand hin- und herschalten kann. Der vierte FET 60 ist so angeordnet, dass er eine Verbindung von dem Bezugspotentialanschluss 42 zu dem Gateanschlusspunkt 56 zwischen einem leitenden und einem nicht leitenden Zustand hin- und herschalten kann. Spezifischer sind dazu der Sourceanschluss des dritten FET 58 mit dem Spannungsanschluss 40 und der Drainanschluss des dritten FET 58 mit dem Sourceanschlusspunkt 54 verbunden bzw. der Sourceanschluss des vierten FET 60 mit dem Bezugspotentialanschluss 42 und der Drainanschluss des vierten FET 60 mit dem Gateanschlusspunkt 56 verbunden. Wenn also an dem ersten Steueranschluss 36 eine Hochpegel-Spannung anliegt, werden der dritte und der vierte FET 58, 60 durchgesteuert. Hochpegel-Spannung ist hier so zu verstehen, dass diese ausreichend hoch gegenüber den Spannungen am Spannungsanschluss 40 und am Bezugspotentialanschluss 42 ist, um den dritten und vierten FET 58, 60 durchzusteuern. Die Ausdrücke durchgesteuert bzw. durchgeschaltet sind so zu verstehen, dass der FET im Sättigungsbereich betrieben wird.

Weiter umfasst die Steuerschaltung 46 einen fünften und einen sechsten FET 62, 64, deren Gateanschlüsse mit dem zweiten Steueranschluss 38 verbunden sind und die bevorzugt MOSFETs sind, weiter bevorzugt n-Kanal MOSFETs vom Anreicherungstyp (d.h. selbstsperrend). Der fünfte und der sechste FET stellen zweite Schaltelemente dar. Der fünfte und der sechste FET 62, 64 sind so in Reihe angeordnet, dass eine Verbindung zwischen dem Sourceanschlusspunkt 54 und dem Gateanschlusspunkt 56 zwischen einem leitenden und einem nicht leitenden Zustand hin- und hergeschaltet werden kann. Wenn also am zweiten Steueranschluss 38 eine Hochpegel-Spannung anliegt, steuern der fünfte und der sechste FET 62, 64 durch. Spezifischer ist der Drainanschluss des fünften FET 62 mit dem Sourceanschlusspunkt 54 verbunden, der Drainanschluss des sechsten FET 64 mit dem Gateanschlusspunkt 56 verbunden und die Sourceanschlüsse des fünften und des sechsten FET 62, 64 sind miteinander verbunden. Auch hier sind der Vollständigkeit halber Bulk-Drain-Dioden 72, 74 des fünften und sechsten FET 62, 64 eingezeichnet. Es sei jedoch betont, dass an dieser Stelle jede ansteuerbare Kurzschlussschaltung eingesetzt werden kann.

Alle FET, d.h. der erste bis sechste FET, sind bevorzugt als Hochvolttransistoren gemäß maximaler Nennspannungen des Busses, beim CAN-Bus z.B. CAN_H, CAN_L von -27 V bis +40 V, ausgelegt bzw. ausgeführt.

Im Folgenden wird unter Bezugnahme auf die oben eingeführten Konfigurationen bzw. Zustände der Steuerspannungen die Funktionsweise der in Figur 3 dargestellten Dämpfungsschaltung beschrieben, wobei vorausgesetzt wird, dass der Spannungsanschluss 40 mit einer geeigneten Spannungsquelle verbunden ist, die eine Spannung zur Verfügung stellt, die bevorzugt der Gleichtaktspannung der beiden Busleitungen entspricht, und dass der Bezugspotentialanschluss 42 mit einem geeigneten Bezugspotential, insbesondere einem Massepotential, verbunden ist.

Erster Zustand (bzw. erste Phase): Wenn am ersten Steueranschluss 36 ein Hochpegel-Spannungssignal anliegt und am zweiten Steueranschluss 38 keine Spannung anliegt, werden der dritte und der vierte FET 58, 60 durchgesteuert, so dass der Sourceanschlusspunkt 54 auf das am Spannungsanschluss 40 anliegende Potential gebracht wird und der Gateanschlusspunkt 56 auf das Potential am Bezugspotentialpunkt 42 gebracht wird (die gemäß vorgenannter Voraussetzung geben sind). Gleichzeitig sperren der fünfte und der sechste FET 62, 64. Dies führt dazu, dass am ersten und am zweiten FET 50, 52 jeweils eine Gate-Source-Spannung anliegt, so dass die beiden FET 50, 52 durchgeschaltet werden, d.h. über die Drain-Source-Strecken nur einen sehr geringen bzw. keinen Widerstand aufweisen. Entsprechend sind die beiden Busleitungen 6, 8 über die in Reihe geschalteten FETs kurzgeschlossen, wobei der Kurzschlusswiderstand, der den Dämpfungswiderstand bildet, durch die Dimensionierung des ersten und des zweiten FET 50, 52 bestimmt ist. Durch den geringen Widerstand zwischen den Busleitungen werden Schwingungen stark gedämpft, d.h. das Ringing unterdrückt.

Zweiter Zustand (bzw. zweite Phase): Wenn am ersten Steueranschluss 36 und am zweiten Steueranschluss 38 keine Spannungen anliegen, sind die Drain-Source-Strecken des dritten, des vierten, des fünften und des sechsten FET 58, 60, 62, 64 nicht leitend. Es besteht dann zwischen dem Sourceanschlusspunkt 54 und dem Gateanschlusspunkt 56 keine leitende Verbindung durch die Steuerschaltung 46, ebenso sind diese von dem Spannungsanschluss 40 und dem Bezugspotentialanschluss 42 (und aufgrund des Schaltungslayouts den Steueranschlüssen 36, 38) getrennt, d.h. der Sourceanschlusspunkt 54 und der Gateanschlusspunkt 56 sind in der Steuerschaltung 46 offen. Die Ladungen der durch die Gate-Source-Kapazitäten des ersten und des zweiten FET 50, 52 gebildeten Kondensatoren entladen sich dann über den Widerstand 48, so dass die Spannung zwischen dem Gateanschlusspunkt 56 und dem Sourceanschlusspunkt 54 abnimmt. Aufgrund der abnehmenden Gate-Source-Spannung an dem ersten und dem zweiten FET 50, 52 befinden sich diese nicht mehr im Sättigungsbereich, sondern im linearen bzw. ohmschen Bereich, so dass die Drain-Source-Strecken, die den Dämpfungswiderstand zwischen den Busleitungen bestimmen, einen von der Gate-Source-Spannung abhängigen Widerstand aufweisen. Entsprechend ist der zeitliche Verlauf des sich ergebenden Dämpfungswiderstands durch die RC-Zeitkonstante bestimmt, die sich aus den Werten C der Gate-Source-Kapazitäten des ersten und des zweiten FET 50, 52 und dem Wert R des Widerstands 48 ergibt.

Dritter Zustand (bzw. dritte Phase): Wenn am ersten Steueranschluss 36 keine Spannung anliegt und am zweiten Steueranschluss 38 ein Hochpegel-Spannungssignal anliegt, werden der fünfte und der sechste FET 62, 64 durchgeschaltet, wobei gleichzeitig der dritte und der vierte FET 58, 60 sperren. Dies führt dazu, dass der Sourceanschlusspunkt 54 und der Gateanschlusspunkt 56 mit geringem bzw. keinem Widerstand verbunden sind. Diese Verbindung ist niederohmig in dem Sinne, dass der Widerstand dieser Verbindung klein ist im Vergleich zum Widerstandswert des Widerstands 48; die Ladungen an den Gate-Source-Kapazitäten des ersten und des zweiten FET 50, 52 fließen also über diese Verbindung ab, so dass der erste und der zweite FET 50, 52 sperren. Damit sind die Busleitungen über die Dämpfungseinrichtung nur hochohmig, d.h. mit hohem Widerstand bzw. nicht leitend, verbunden.

Offensichtlich sollte nicht am ersten und am zweiten Steueranschluss 36, 38 gleichzeitig ein Hochpegel-Spannungssignal angelegt werden, da dann der Spannungsanschluss 40 direkt mit dem Bezugspotentialanschluss 42 verbunden würde. Eine Ansteuereinrichtung 20 sollte entsprechend eingerichtet sein.

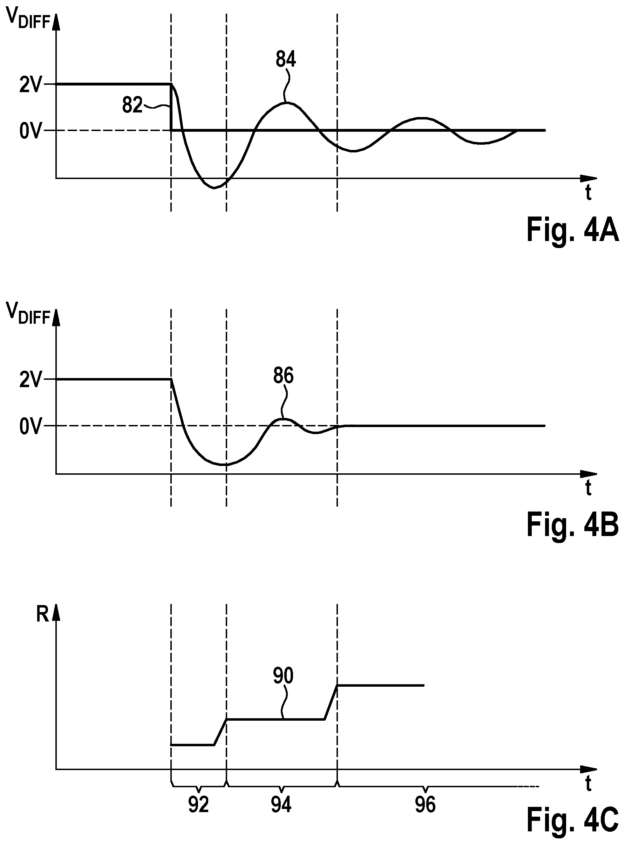

In den Figuren 4A-4C ist der Effekt einer erfindungsgemäßen Dämpfungsschaltung skizziert. Dabei ist in Figur 4A zunächst das Verhalten dargestellt, wenn keine Dämpfungsschaltung verwendet wird, wobei die Differenzspannung V_{Diff} zwischen den Busleitungen gegen die Zeit t aufgetragen ist. In der Figur sind sowohl der ideale Verlauf 82 als auch der reale Verlauf 84 der Differenzspannung aufgetragen. Der ideale Verlauf 82 folgt einem stufenförmigen Verlauf, bei dem die Differenzspannung von einem positiven Wert (z.B. 2 V im CAN-Bus) auf einen Wert von 0 V übergeht. Der reale Verlauf 84 weist hingegen Schwingungen (Ringing) auf, die an der Flanke des idealen Verlaufs entstehen und die erst nach einigen Schwingungsperioden auf einen vernachlässigbaren Wert gedämpft werden.

In Figur 4B ist der gedämpfte Verlauf 86 dargestellt, d.h. der Verlauf des realen Differenzspannungssignals, wenn eine Dämpfungsschaltung verwendet wird. Hier ist die Schwingung im Wesentlichen nach bereits einer Schwingungsperiode auf relativ kleine Ausschläge gedämpft. Der Zustand von 0 V ist also für einen Empfänger am Bus bereits deutlich früher eindeutig unterscheidbar.

In Figur 4C ist der Verlauf 90 des Widerstands, der durch die erfindungsgemäße Dämpfungsschaltung zwischen den beiden Busleitungen eingestellt wird, dargestellt, wobei lediglich der prinzipielle Verlauf, d.h. ob der Widerstand in einer Phase größer oder kleiner als in einer anderen ist, skizziert ist und sich aus der Figur keine Aussagen über die absolute Größe ablesen lassen, auch können die Widerstände während einer Phase möglicherweise nicht konstant sein, dies ist insbesondere während der zweiten Phase der Fall, in der der erste und zweite Transistor als spannungsgesteuerte Widerstände wirken und die Gate-Source-Spannung entsprechend der durch die Gate-Source-Kapazitäten und das Widerstandselement definierten RC-Zeitkonstante abnimmt. Während der ersten Phase 92 (erster Zustand bzw. Zeitraum, d.h. erster und zweiter Transistor durchgesteuert) sind die Busleitungen durch einen sehr niedrigen Widerstand der Dämpfungsschaltung miteinander verbunden, bzw. kurzgeschlossen, wodurch die Schwingung stark gedämpft wird (da mit dem Widerstand R auch eine entsprechende Zeitkonstante RC klein ist). In der zweiten Phase 94 (zweiter Zustand bzw. Zeitraum, d.h. erster und zweiter Transistor verhalten sich als spannungsgesteuerte Widerstände) wird der Widerstand über die Dämpfungsschaltung erhöht, so dass auch schwächere Bus-Teilnehmer eine Differenzspannung auf dem Bus erzeugen können, wobei gleichzeitig der Widerstand immer noch klein genug ist, um die Schwingung weiter zu dämpfen. Im weiteren Verlauf bzw. in der dritten Phase 96 (dritter Zustand bzw. Zeitraum, d.h. erster und zweiter Transistor sperren) sind die Busleitungen über die Dämpfungsschaltung nicht mehr, bzw. nur mit sehr hohem Widerstand, miteinander verbunden. Die erste bis dritte Phase entsprechend dem obig eingeführten ersten bis dritten Zustand der Steuerspannungen.

## Patentansprüche

1. Verfahren zum Dämpfen von Schwingungen auf Busleitungen eines auf Differenzspannungssignalen basierenden Bussystems, insbesondere eines Controller-Area-Network-Bussystems, unter Verwendung einer Dämpfungseinrichtung (30) für einen Bus (10) des Bussystems (2), wobei der Bus eine erste Busleitung (6) und eine zweite Busleitung (8) aufweist,
wobei die Dämpfungseinrichtung (30) eine Dämpfungsschaltung (44) aufweist, die einen variablen elektrischen Widerstandswert zwischen der ersten Busleitung (6) und der zweiten Busleitung (8) bereitstellt und die in wenigstens drei Schaltungszuständen betreibbar ist,
wobei in einem ersten Schaltungszustand die erste Busleitung (6) und die zweite Busleitung (8) über einen Dämpfungswiderstand (50, 52) mit einem ersten Widerstandswert verbunden sind,
wobei in einem zweiten Schaltungszustand die erste Busleitung (6) und die zweite Busleitung (8) über einen Dämpfungswiderstand (50, 52) mit einem zweiten Widerstandswert verbunden sind, und
wobei in einem dritten Schaltungszustand die erste Busleitung (6) und die zweite Busleitung (8) über einen Dämpfungswiderstand (50, 52) mit einem dritten Widerstandswert verbunden sind,
wobei der erste Widerstandswert kleiner als der zweite Widerstandswert, und der zweite Widerstandswert kleiner als der dritte Widerstandswert ist, wobei die Dämpfungseinrichtung (30) weiterhin eine Steuerschaltung (46) mit einem ersten und einem zweiten Steueranschluss (36, 38) aufweist, welche die Dämpfungsschaltung zwischen den einzelnen Schaltungszuständen nach Maßgabe von Spannungssignalen an dem ersten und dem zweiten Steueranschluss (36, 38) hin- und herschaltet,
das Verfahren umfassend:
Erkennen einer Flanke im Differenzspannungssignal;
wenn die Flanke erkannt wird, Bereitstellen mindestens einer Spannung an dem ersten und dem zweiten Steueranschluss , wobei
- in einem ersten Zeitraum die mindestens eine Spannung gemäß dem ersten Schaltungszustand bereitgestellt wird,
- in einem zweiten Zeitraum, der sich an den ersten Zeitraum anschließt, die mindestens eine Spannung gemäß dem zweiten Schaltungszustand bereitgestellt wird, und
- in einem dritten Zeitraum, der außerhalb des ersten und des zweiten Zeitraums liegt, die mindestens eine Spannung gemäß dem dritten Schaltungszustand bereitgestellt wird.

2. Verfahren nach Anspruch 1, wobei die Flanke eine fallende Flanke des Differenzspannungssignals ist.

3. Verfahren nach einem der Ansprüche 1 oder 2, wobei, wenn die Flanke erkannt wird, in dem ersten Zeitraum an dem ersten Steueranschluss ein Hochpegel-Spannungssignal und am zweiten Steueranschluss kein Spannungssignal bereitgestellt werden, in dem zweiten Zeitraum an dem ersten und am zweiten Steueranschluss keine Spannungssignale bereitgestellt werden, und in dem dritten Zeitraum an dem ersten Steueranschluss kein Spannungssignal und am zweiten Steueranschluss ein Hochpegel-Spannungssignal bereitgestellt werden.

4. Dämpfungseinrichtung (30) für einen Bus (10) eines auf Differenzspannungssignalen basierenden Bussystems (2), insbesondere eines Controller-Area-Network-Bussystems, wobei der Bus eine erste Busleitung (6) und eine zweite Busleitung (8) aufweist, aufweisend eine Dämpfungsschaltung (44), die einen variablen elektrischen Widerstandswert zwischen der ersten Busleitung (6) und der zweiten Busleitung (8) bereitstellt und die in wenigstens drei Schaltungszuständen betreibbar ist,
wobei in einem ersten Schaltungszustand die erste Busleitung (6) und die zweite Busleitung (8) über einen Dämpfungswiderstand (50, 52) mit einem ersten Widerstandswert verbunden sind,
wobei in einem zweiten Schaltungszustand die erste Busleitung (6) und die zweite Busleitung (8) über einen Dämpfungswiderstand (50, 52) mit einem zweiten Widerstandswert verbunden sind, und
wobei in einem dritten Schaltungszustand die erste Busleitung (6) und die zweite Busleitung (8) über einen Dämpfungswiderstand (50, 52) mit einem dritten Widerstandswert verbunden sind,
wobei der erste Widerstandswert kleiner als der zweite Widerstandswert, und der zweite Widerstandswert kleiner als der dritte Widerstandswert ist,
weiterhin aufweisend eine Steuerschaltung (46) mit einem ersten und einem zweiten Steueranschluss (36, 38), welche die Dämpfungsschaltung zwischen den einzelnen Schaltungszuständen nach Maßgabe von Spannungssignalen an dem ersten und dem zweiten Steueranschluss (36, 38) hin- und herschaltet,
mit einer Ansteuerungseinrichtung (20), die Anschlusselemente zum Verbinden an die erste und die zweite Busleitung und wenigstens einen Ausgang zum Verbinden mit dem ersten und dem zweiten Steueranschluss (36, 38) aufweist, und die dazu eingerichtet ist, alle Verfahrensschritte eines Verfahrens nach einem der Ansprüche 1 bis 3 durchzuführen, wobei vorbestimmte erste und zweite Zeiträume verwendet werden.

5. Dämpfungseinrichtung (30) nach Anspruch 4, wobei der zweite Widerstandswert mit der Zeit ansteigt.

6. Dämpfungseinrichtung (30) nach Anspruch 4 oder 5, wobei der Dämpfungswiderstand (50, 52) mit dem ersten Widerstandswert und/oder der Dämpfungswiderstand (50, 52) mit dem zweiten Widerstandswert und/oder der Dämpfungswiderstand (50, 52) mit dem dritten Widerstandswert als Schaltung aufweisend wenigstens einen Halbleiterschalter realisiert sind.

7. Dämpfungseinrichtung (30) nach einem der Ansprüche 4 bis 6, die einen ersten Feldeffekttransistor, FET, (50) mit einer vorbestimmten Gate-Source-Kapazität, einen zweiten FET (52) mit einer vorbestimmten Gate-Source-Kapazität und ein Widerstandselement (48) mit einem vorbestimmten Widerstandswert umfasst, wobei ein Drainanschluss des ersten FET mit einem Anschluss (32) für die erste Busleitung verbunden ist und ein Drainanschluss des zweiten FET mit einem Anschluss (34) für die zweite Busleitung verbunden ist, wobei ein Sourceanschluss des ersten FET und ein Sourceanschluss des zweiten FET mit einem gemeinsamen Sourceanschlusspunkt (54) verbunden sind, wobei ein Gateanschluss des ersten FET und ein Gateanschluss des zweiten FET mit einem gemeinsamen Gateanschlusspunkt (56) verbunden sind, und wobei das Widerstandselement mit dem Sourceanschlusspunkt und dem Gateanschlusspunkt verbunden ist.

8. Dämpfungseinrichtung (30) nach Anspruch 7, wobei die Steuerschaltung (46) mit dem Gateanschlusspunkt und dem Sourceanschlusspunkt der Dämpfungsschaltung verbunden ist und einen Spannungsanschluss (40) und einen Bezugspotentialanschluss (42) aufweist; wobei die Steuerschaltung dazu eingerichtet ist, wenn an dem Spannungsanschluss eine Spannung anliegt und an dem Bezugspotentialanschluss ein Bezugspotential anliegt:
den Sourceanschlusspunkt mit dem Spannungsanschluss zu verbinden und den Gateanschlusspunkt mit dem Bezugspotentialanschluss zu verbinden, wenn an dem ersten und dem zweiten Steueranschluss die mindestens eine Spannung anliegt, die den ersten Schaltungszustand signalisiert;
den Sourceanschlusspunkt und den Gateanschlusspunkt in der Steuerschaltung offen zu schalten, wenn an dem ersten und dem zweiten Steueranschluss die mindestens eine Spannung anliegt, die den zweiten Schaltungszustand signalisiert;
den Sourceanschlusspunkt mit dem Gateanschlusspunkt niederohmig zu verbinden, wenn an dem ersten und dem zweiten Steueranschluss die mindestens eine Spannung anliegt, die den dritten Schaltungszustand signalisiert.

9. Dämpfungseinrichtung nach Anspruch 8,
wobei der erste Schaltungszustand dadurch signalisiert wird, dass an dem ersten Steueranschluss ein Hochpegel-Spannungssignal anliegt und an dem zweiten Steueranschluss kein Spannungssignal anliegt;
wobei der zweite Schaltungszustand dadurch signalisiert wird, dass an dem ersten Steueranschluss und an dem zweiten Steueranschluss keine Spannungssignale anliegen; und
wobei der dritte Schaltungszustand dadurch signalisiert wird, dass an dem zweiten Steueranschluss ein Hochpegel-Spannungssignal anliegt und an dem ersten Steueranschluss kein Spannungssignal anliegt.

10. Dämpfungseinrichtung nach Anspruch 9, wobei die Steuerschaltung (46) erste Schaltelemente aufweist, die dazu eingerichtet sind, eine Verbindung zwischen dem Spannungsanschluss und dem Sourceanschlusspunkt und eine Verbindung zwischen dem Bezugspotentialanschluss und dem Gateanschlusspunkt in einen leitenden Zustand zu schalten, wenn am ersten Steueranschluss ein Hochpegel-Spannungssignal anliegt, und in einen nicht leitenden Zustand zu schalten, wenn am ersten Steueranschluss kein Spannungssignal anliegt;
wobei bevorzugt die ersten Schaltelemente einen dritten und einen vierten FET (58, 60) umfassen, wobei Gateanschlüsse des dritten und des vierten FET mit dem ersten Steueranschluss verbunden sind;
wobei weiter bevorzugt ein Sourceanschluss des dritten FET (58) mit dem Spannungsanschluss und ein Drainanschluss des dritten FET mit dem Sourceanschlusspunkt verbunden sind, und ein Sourceanschluss des vierten FET (60) mit dem Bezugspotentialanschluss und ein Drainanschluss des vierten FET mit dem Gateanschlusspunkt verbunden sind.

11. Dämpfungseinrichtung nach einem der Ansprüche 9 oder 10, wobei die Steuerschaltung zweite Schaltelemente aufweist, die dazu eingerichtet sind, eine Verbindung zwischen dem Sourceanschlusspunkt und dem Gateanschlusspunkt in einen leitenden Zustand zu schalten, wenn am zweiten Steueranschluss ein Hochpegel-Spannungssignal anliegt, und in einen nicht leitenden Zustand zu schalten, wenn am zweiten Steueranschluss kein Spannungssignal anliegt;
wobei bevorzugt die zweiten Schaltelemente einen fünften und einen sechsten FET (62, 64) umfassen, die in Reihe geschaltet sind, wobei Gateanschlüsse des fünften und des sechsten FET mit dem zweiten Steueranschluss verbunden sind;
wobei weiter bevorzugt ein Sourceanschluss des fünften FET (62) mit einem Sourceanschluss des sechsten FET (64) verbunden ist, und ein Drainanschluss des fünften FET mit dem Sourceanschlusspunkt und ein Drainanschluss des sechsten FET mit dem Gateanschlusspunkt verbunden sind.

12. Dämpfungsanordnung umfassend mehrere an den Busleitungen parallel geschaltete Dämpfungseinrichtungen gemäß einem der Ansprüche 4 bis 11.

13. Dämpfungsanordnung nach Anspruch 12, wenn abhängig von Anspruch 7, wobei die vorbestimmte Gate-Source-Kapazität und/oder der vorbestimmte Widerstandswert verschiedener Dämpfungseinrichtungen unterschiedliche Werte aufweisen, wobei bevorzugt RC-Zeitkonstanten verschiedener Dämpfungseinrichtungen unterschiedlich sind.

## Claims

1. Method for attenuating oscillations on bus lines of a bus system based on differential voltage signals, in particular a controller area network bus system, using an attenuation device (30) for a bus (10) of the bus system (2), wherein the bus has a first bus line (6) and a second bus line (8),
wherein the attenuation device (30) has an attenuation circuit (44) which provides a variable electrical resistance value between the first bus line (6) and the second bus line (8) and which is able to be operated in at least three circuit states,
wherein, in a first circuit state, the first bus line (6) and the second bus line (8) are connected to a first resistance value via an attenuation resistor (50, 52),
wherein, in a second circuit state, the first bus line (6) and the second bus line (8) are connected to a second resistance value via an attenuation resistor (50, 52), and
wherein, in a third circuit state, the first bus line (6) and the second bus line (8) are connected to a third resistance value via an attenuation resistor (50, 52),
wherein the first resistance value is less than the second resistance value, and the second resistance value is less than the third resistance value,
wherein the attenuation device (30) further has a control circuit (46) with a first and a second control connection (36, 38), which control circuit switches the attenuation circuit back and forth between the individual circuit states according to voltage signals at the first and the second control connection (36, 38),
the method comprising:
detecting an edge in the differential voltage signal;
if the edge is detected, providing at least one voltage at the first and the second control connection, wherein
- during a first period of time, the at least one voltage is provided according to the first circuit state,
- during a second period of time, which follows the first period of time, the at least one voltage is provided according to the second circuit state, and
- during a third period of time, which lies outside the first and the second period of time, the at least one voltage is provided according to the third circuit state.

2. Method according to Claim 1, wherein the edge is a falling edge of the differential voltage signal.

3. Method according to either of Claims 1 and 2, wherein, if the edge is detected, during the first period of time a high-level voltage signal is provided at the first control connection and no voltage signal is provided at the second control connection, during the second period of time no voltage signals are provided at the first and at the second control connection, and during the third period of time no voltage signal is provided at the first control connection and a high-level voltage signal is provided at the second control connection.

4. Attenuation device (30) for a bus (10) of a bus system (2) based on differential voltage signals, in particular a controller area network bus system, wherein the bus has a first bus line (6) and a second bus line (8), having an attenuation circuit (44) which provides a variable electrical resistance value between the first bus line (6) and the second bus line (8) and which is able to be operated in at least three circuit states,
wherein, in a first circuit state, the first bus line (6) and the second bus line (8) are connected to a first resistance value via an attenuation resistor (50, 52),
wherein, in a second circuit state, the first bus line (6) and the second bus line (8) are connected to a second resistance value via an attenuation resistor (50, 52), and
wherein, in a third circuit state, the first bus line (6) and the second bus line (8) are connected to a third resistance value via an attenuation resistor (50, 52),
wherein the first resistance value is less than the second resistance value, and the second resistance value is less than the third resistance value,
further having a control circuit (46) with a first and a second control connection (36, 38), which control circuit switches the attenuation circuit back and forth between the individual circuit states according to voltage signals at the first and the second control connection (36, 38),
with an actuation device (20) which has connection elements for connecting to the first and the second bus line and at least one output for connecting to the first and the second control connection (36, 38), and which is set up to carry out all the method steps of a method according to one of Claims 1 to 3, wherein predetermined first and second periods of time are used.

5. Attenuation device (30) according to Claim 4, wherein the second resistance value increases over time.

6. Attenuation device (30) according to Claim 4 or 5, wherein the attenuation resistor (50, 52) with the first resistance value and/or the attenuation resistor (50, 52) with the second resistance value and/or the attenuation resistor (50, 52) with the third resistance value are realized as a circuit having at least one semiconductor switch.

7. Attenuation device (30) according to one of Claims 4 to 6, which comprises a first field-effect transistor, FET, (50) with a predetermined gate-source capacitance, a second FET (52) with a predetermined gate-source capacitance, and a resistor element (48) with a predetermined resistance value, wherein a drain connection of the first FET is connected to a connection (32) for the first bus line and a drain connection of the second FET is connected to a connection (34) for the second bus line, wherein a source connection of the first FET and a source connection of the second FET are connected to a common source connection point (54), wherein a gate connection of the first FET and a gate connection of the second FET are connected to a common gate connection point (56), and wherein the resistor element is connected to the source connection point and the gate connection point.

8. Attenuation device (30) according to Claim 7, wherein the control circuit (46) is connected to the gate connection point and to the source connection point of the attenuation circuit and has a voltage connection (40) and a reference potential connection (42); wherein the control circuit is set up to, if a voltage is applied to the voltage connection and a reference potential is applied to the reference potential connection:
connect the source connection point to the voltage connection and connect the gate connection point to the reference potential connection if the at least one voltage is applied to the first and the second control connection, indicating the first circuit state;
switch open the source connection point and the gate connection point in the control circuit if the at least one voltage is applied to the first and the second control connection, indicating the second circuit state;
connect the source connection point to the gate connection point with low resistance if the at least one voltage is applied to the first and the second control connection, indicating the third circuit state.

9. Attenuation device according to Claim 8,
wherein the first circuit state is indicated by the fact that a high-level voltage signal is applied to the first control connection and no voltage signal is applied to the second control connection;
wherein the second circuit state is indicated by the fact that no voltage signals are applied to the first control connection and to the second control connection; and
wherein the third circuit state is indicated by the fact that a high-level voltage signal is applied to the second control connection and no voltage signal is applied to the first control connection.

10. Attenuation device according to Claim 9, wherein the control circuit (46) has first switching elements which are set up to switch a connection between the voltage connection and the source connection point and a connection between the reference potential connection and the gate connection point into an ON state if a high-level voltage signal is applied to the first control connection, and switch them into an OFF state if no voltage signal is applied to the first control connection;
wherein preferably the first switching elements comprise a third and a fourth FET (58, 60), wherein gate connections of the third and the fourth FET are connected to the first control connection;
wherein further preferably a source connection of the third FET (58) is connected to the voltage connection and a drain connection of the third FET is connected to the source connection point, and a source connection of the fourth FET (60) is connected to the reference potential connection and a drain connection of the fourth FET is connected to the gate connection point.

11. Attenuation device according to either of Claims 9 and 10, wherein the control circuit has second switching elements which are set up to switch a connection between the source connection point and the gate connection point into an ON state if a high-level voltage signal is applied to the second control connection, and to switch them into an OFF state if no voltage signal is applied to the second control connection;
wherein preferably the second switching elements comprise a fifth and a sixth FET (62, 64) which are connected in series, wherein gate connections of the fifth and the sixth FET are connected to the second control connection;
wherein further preferably a source connection of the fifth FET (62) is connected to a source connection of the sixth FET (64), and a drain connection of the fifth FET is connected to the source connection point and a drain connection of the sixth FET is connected to the gate connection point.

12. Attenuation arrangement comprising a plurality of attenuation devices according to one of Claims 4 to 11 connected in parallel to the bus lines.

13. Attenuation arrangement according to Claim 12, when dependent on Claim 7, wherein the predetermined gate-source capacitance and/or the predetermined resistance value of different attenuation devices have different values, wherein preferably RC time constants of different attenuation devices are different.

## Revendications

1. Procédé d'atténuation d'oscillations sur des lignes de bus d'un système de bus sur la base de signaux de tension différentielle, en particulier d'un système de bus Controller-Area-Network, en utilisant un dispositif d'amortissement (30) pour un bus (10) du système de bus (2), le bus présentant une première ligne de bus (6) et une deuxième ligne de bus (8),
dans lequel le dispositif d'atténuation (30) présente un circuit d'atténuation (44) qui fournit une valeur de résistance électrique variable entre la première ligne de bus (6) et la deuxième ligne de bus (8) et qui peut fonctionner dans au moins trois états de circuit,
dans lequel, dans un premier état de circuit, la première ligne de bus (6) et la deuxième ligne de bus (8) sont reliées par l'intermédiaire d'une résistance d'atténuation (50, 52) possédant une première valeur de résistance,
dans lequel, dans un deuxième état de circuit, la première ligne de bus (6) et la deuxième ligne de bus (8) sont reliées par l'intermédiaire d'une résistance d'atténuation (50, 52) possédant une deuxième valeur de résistance, et
dans lequel, dans un troisième état de circuit, la première ligne de bus (6) et la deuxième ligne de bus (8) sont reliées par l'intermédiaire d'une résistance d'atténuation (50, 52) possédant une troisième valeur de résistance,
dans lequel la première valeur de résistance est inférieure à la deuxième valeur de résistance et la deuxième valeur de résistance est inférieure à la troisième valeur de résistance,
dans lequel le dispositif d'atténuation (30) présente en outre un circuit de commande (46) avec une première et une deuxième borne de commande (36, 38) qui commutent le circuit d'atténuation entre les états de circuit individuels en fonction de signaux de tension sur la première et la deuxième bornes de commande (36, 38),
le procédé comprenant :
détection d'un front dans le signal de tension différentielle ;
lorsque le front est détecté, fourniture d'au moins une tension à la première et à la deuxième bornes de commande, dans lequel
- dans un premier intervalle de temps, la au moins une tension est fournie selon le premier état de circuit,
- dans un deuxième intervalle de temps qui suit le premier intervalle de temps, la au moins une tension est fournie selon le deuxième état de circuit, et
- dans un troisième intervalle de temps qui se situe en dehors du premier et du deuxième intervalles de temps, la au moins une tension est fournie selon le troisième état de circuit.

2. Procédé selon la revendication 1, dans lequel le front est un front descendant du signal de tension différentielle.

3. Procédé selon l'une des revendications 1 ou 2, dans lequel, lorsque le front est détecté, dans le premier intervalle de temps, un signal de tension de haut niveau est fourni à la première borne de commande et aucun signal de tension n'est fourni à la deuxième borne de commande, dans le deuxième intervalle de temps, aucun signal de tension n'est fourni à la première et à la deuxième bornes de commande, et dans le troisième intervalle de temps, aucun signal de tension n'est fourni à la première borne de commande et un signal de tension de haut niveau est fourni à la deuxième borne de commande.

4. Dispositif d'atténuation (30) pour un bus (10) d'un système de bus (2) sur la base de signaux de tension différentielle, en particulier d'un système de bus Controller-Area-Network, dans lequel le bus présente une première ligne de bus (6) et une deuxième ligne de bus (8), comprenant un circuit d'atténuation (44) qui fournit une valeur de résistance électrique variable entre la première ligne de bus (6) et la deuxième ligne de bus (8) et qui peut fonctionner dans au moins trois états de circuit,
dans lequel, dans un premier état de circuit, la première ligne de bus (6) et la deuxième ligne de bus (8) sont reliées par l'intermédiaire d'une résistance d'atténuation (50, 52) possédant une première valeur de résistance,
dans lequel, dans un deuxième état de circuit, la première ligne de bus (6) et la deuxième ligne de bus (8) sont reliées par l'intermédiaire d'une résistance d'atténuation (50, 52) possédant une deuxième valeur de résistance, et
dans lequel, dans un troisième état de circuit, la première ligne de bus (6) et la deuxième ligne de bus (8) sont reliées par l'intermédiaire d'une résistance d'atténuation (50, 52) possédant une troisième valeur de résistance,
dans lequel la première valeur de résistance est inférieure à la deuxième valeur de résistance et la deuxième valeur de résistance est inférieure à la troisième valeur de résistance,
comprenant en outre un circuit de commande (46) avec une première et une deuxième bornes de commande (36, 38) qui commutent le circuit d'atténuation entre les états de circuit individuels en fonction de signaux de tension sur la première et la deuxième bornes de commande (36, 38),
avec un dispositif de commande (20), qui présente des éléments de borne pour la connexion à la première et à la deuxièmes ligne de bus et au moins une sortie pour la connexion à la première et à la deuxième bornes de commande (36, 38), et qui est conçu pour exécuter toutes les étapes de procédé d'un procédé selon l'une des revendications 1 à 3, dans lequel des première et deuxième périodes de temps prédéterminées sont utilisées.

5. Dispositif d'atténuation (30) selon la revendication 4, dans lequel la deuxième valeur de résistance augmente avec le temps.

6. Dispositif d'atténuation (30) selon la revendication 4 ou 5, dans lequel la résistance d'atténuation (50, 52) avec la première valeur de résistance et/ou la résistance d'atténuation (50, 52) avec la deuxième valeur de résistance et/ou la résistance d'atténuation (50, 52) avec la troisième valeur de résistance sont réalisées sous la forme d'un circuit présentant au moins un commutateur à semi-conducteur.

7. Dispositif d'atténuation (30) selon l'une des revendications 4 à 6, qui comprend un premier transistor à effet de champ, FET, (50) avec une capacité grille-source prédéterminée, un deuxième FET (52) avec une capacité grille-source prédéterminée et un élément résistif (48) avec une valeur de résistance prédéterminée, dans lequel une borne de drain du premier FET est reliée à une borne (32) pour la première ligne de bus et une borne de drain du deuxième FET est reliée à une borne (34) pour la deuxième ligne de bus, dans lequel une borne de source du premier FET et une borne de source du deuxième FET sont reliées à un point de connexion de source commun (54), dans lequel une borne de grille du premier FET et une borne de grille du deuxième FET sont connectées à un point de connexion de grille commun (56), et dans lequel l'élément résistif est relié au point de connexion de source et au point de connexion de grille.

8. Dispositif d'atténuation (30) selon la revendication 7, dans lequel le circuit de commande (46) est relié au point de connexion de grille et au point de connexion de source du circuit d'atténuation et présente une borne de tension (40) et une borne de potentiel de référence (42) ; dans lequel le circuit de commande est conçu, lorsqu'une tension est appliquée sur la borne de tension et qu'un potentiel de référence est appliqué sur la borne de potentiel de référence, pour :
relier le point de connexion de source à la borne de tension et relier le point de connexion de grille à la borne de potentiel de référence, lorsque la au moins une tension signalant le premier état de circuit est appliquée sur la première et la deuxième bornes de commande ;
commuter le point de connexion de source et le point de connexion de grille dans le circuit de commande à l'état ouvert, lorsque la au moins une tension signalant le deuxième état de circuit est appliquée sur la première et la deuxième bornes de commande ;
relier le point de connexion de source au point de connexion de grille à basse impédance, lorsque la au moins une tension signalant le troisième état de circuit est appliquée sur la première et la deuxième bornes de commande.

9. Dispositif d'atténuation selon la revendication 8,
dans lequel le premier état de circuit est signalé par le fait qu'un signal de tension de haut niveau est appliqué sur la première borne de commande et qu'aucun signal de tension n'est appliqué sur la deuxième borne de commande ;
dans lequel le deuxième état de circuit est signalé par le fait qu'aucun signal de tension n'est appliqué sur la première borne de commande et sur la deuxième borne de commande ; et
dans lequel le troisième état de circuit est signalé par le fait qu'un signal de tension de haut niveau est appliqué sur la deuxième borne de commande et qu'aucun signal de tension n'est appliqué sur la première borne de commande.

10. Dispositif d'atténuation selon la revendication 9, dans lequel le circuit de commande (46) comprend des premiers éléments de commutation qui sont conçus pour commuter une connexion entre la borne de tension et le point de connexion de source et une connexion entre la borne de potentiel de référence et le point de connexion de grille dans un état conducteur lorsqu'un signal de tension de haut niveau est appliqué sur la première borne de commande, et à un état non conducteur lorsqu'aucun signal de tension n'est appliqué sur la première borne de commande ;
dans lequel les premiers éléments de commutation comprennent de préférence un troisième et un quatrième FET (58, 60), les bornes de grille du troisième et du quatrième FET étant reliées à la première borne de commande ;
dans lequel une borne de source du troisième FET (58) est en outre reliée à la borne de tension et une borne de drain du troisième FET est reliée au point de connexion de source, et une borne de source du quatrième FET (60) est reliée à la borne de potentiel de référence et une borne de drain du quatrième FET est reliée au point de connexion de grille.

11. Dispositif d'atténuation selon l'une des revendications 9 ou 10, dans lequel le circuit de commande présente des deuxièmes éléments de commutation qui sont conçus pour commuter une connexion entre le point de connexion de source et le point de connexion de grille dans un état conducteur lorsqu'un signal de tension de haut niveau est appliqué sur la deuxième borne de commande, et à un état non conducteur lorsqu'aucun signal de tension n'est appliqué sur la deuxième borne de commande ;
dans lequel les deuxièmes éléments de commutation comprennent de préférence un cinquième et un sixième FET (62, 64), qui sont montés en série, les bornes de grille du cinquième et du sixième FET étant reliées à la deuxième borne de commande ;
dans lequel une borne de source du cinquième FET (62) est en outre de préférence reliée à une borne de source du sixième FET (64), et une borne de drain du cinquième FET est reliée au point de connexion de source et une borne de drain du sixième FET est reliée au point de connexion de grille.

12. Agencement d'atténuation comprenant plusieurs dispositifs d'atténuation connectés en parallèle aux lignes de bus selon l'une des revendications 4 à 11.

13. Agencement d'atténuation selon la revendication 12, lorsque dépendante de la revendication 7, dans lequel la capacité grille-source prédéterminée et/ou la valeur de résistance prédéterminée de différents dispositifs d'atténuation présentent des valeurs différentes, dans lequel les constantes de temps RC de différents dispositifs d'atténuation sont de préférence différentes.
